# FASCICULE DE BREVET EUROPEEN

(11) **EP 2 109 884 B1**
(45) Date de publication et mention de la délivrance du brevet: **29.02.2012**
(21) Numéro de dépôt: 08716770.6
(22) Date de dépôt: 07.02.2008
(51) Int. Cl.: H01L 21/762

(54) **PROCEDE DE PREPARATION D'UNE COUCHE DE GERMANIUM A PARTIR D'UN SUBSTRAT SILICIUM-GERMANIUM-SUR-ISOLANT**
VERFAHREN ZUR HERSTELLUNG EINER GERMANIUMSCHICHT AUS EINEM SILICIUM-GERMANIUM-SUBSTRAT AUF EINEM ISOLATOR
METHOD FOR PREPARING A GERMANIUM LAYER FROM AN SILICON-GERMANIUM ON-INSULATOR SUBSTRATE

(30) Priorité: 08.02.2007 FR 0753146
(43) Date de publication de la demande: 21.10.2009
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: VINCENT, Benjamin, F-38000 Grenoble (FR); DAMLENCOURT, Jean-François, F-38190 Laval (FR); MORAND, Yves, F-38000 Grenoble (FR)
(74) Mandataire: Ilgart, Jean-Christophe
(86) Numéro de dépôt international: PCT/EP2008/051511
(87) Numéro de publication internationale: WO 2008/101813

(56) Documents cités:
- US-A1- 2005 042 842
- DATABASE EPODOC EUROPEAN PATENT OFFICE, THE HAGUE, NL; KR20010061783 7 juillet 2001 (2001-07-07), "METHOD FOR MANUFACTURING METAL-OXIDE-SEMICONDUCTOR TRANSISTOR" XP002442611 -& KR 2001 0061783 A (HYNIX SEMICONDUCTOR INC [KR]) 7 juillet 2001 (2001-07-07)
- NAKAHARAI S ET AL: "CHARACTERIZATION OF 7-NM-THICK STRAINED GE-ON-INSULATOR LAYER FABRICATED BY GE-CONDENSATION TECHNIQUE" APPLIED PHYSICS LETTERS, AIP, AMERICAN INSTITUTE OF PHYSICS, MELVILLE, NY, US, vol. 83, no. 17, 27 octobre 2003 (2003-10-27), pages 3516-3518, XP001192557 ISSN: 0003-6951
- LIU YAOCHENG ET AL: "High-quality single-crystal Ge on insulator by liquid-phase epitaxy on Si substrates" APPLIED PHYSICS LETTERS, AIP, AMERICAN INSTITUTE OF PHYSICS, MELVILLE, NY, US, vol. 84, no. 14, 5 avril 2004 (2004-04-05), pages 2563-2565, XP012060995 ISSN: 0003-6951

## Description

### DOMAINE TECHNIQUE

L'invention se rapporte à un procédé d'élaboration d'une couche de germanium à partir d'un substrat silicium-germanium-sur-isolant (dénommé par la suite substrat SGOI correspondant à la terminologie anglaise « silicium-germanium-on-insulator ») sur lequel est déposée une couche métallique appropriée.

Ce procédé trouve son application en particulier pour la préparation de transistors MOS à effet de champ (dit transistor MOSFET).

Le domaine général de l'invention est donc celui de la microélectronique.

Les technologies de la microélectronique sont jusqu'à présent principalement basées sur l'utilisation du silicium. Toutefois, eu égard au besoin d'élaborer des dispositifs de plus en plus rapides, substituer le silicium par un semi-conducteur présentant une mobilité de porteurs plus importante que celle du silicium est fortement envisagé. Le germanium répond à ce critère, en ce sens qu'il a pour particularité de présenter une mobilité de trous et d'électrons plus importante que le silicium. Cependant, le germanium présente de façon inhérente de forts courants de fuite, ce qui fait qu'il ne peut être utilisé que sous forme GeOI, c'est-à-dire germanium-sur-isolant, grâce à quoi les courants de fuite sont diminués et le germanium est utilisé en de très faibles quantités réduisant ainsi la masse des substrats.

Différentes techniques de fabrication de substrats germanium-sur-isolant ou silicium-germanium-sur-isolant (SGOI) sont proposées dans la littérature.

Ainsi, dans l'article intitulé " *200 mm Germanium-on-insulator (GeOI) structures realized from epitaxial wafers using the smart CUT^{™} technology"* issu de *« Proceeding ECS 2005 Conference »* de Deguet et al. [1], il est décrit un procédé mettant en jeu, de façon globale, les étapes suivantes :
- une étape de dépôt, sur un wafer en silicium comportant en surface une couche de germanium, d'une couche d'oxyde, destinée à constituer une couche d'oxyde enterré ;
- une étape de fixation de ce wafer, après traitement de celui-ci, sur un substrat de base, la fixation se faisant par le biais de la couche d'oxyde ;
- une étape de clivage de la structure obtenue de façon à faire affleurer la couche de germanium, à l'issue de laquelle l'on obtient un substrat germanium-sur-isolant.

De part ces dernières étapes, ce procédé est de mise en oeuvre complexe et est coûteux. Qui plus est, il ne permet pas la co-intégration de structures silicium-sur-isolant/germanium-sur-isolant.

Une deuxième approche consiste à élaborer un substrat germanium-sur-isolant par croissance épitaxique en phase liquide du germanium, tel que décrit dans *Applied Physics Letters, Viol. 84, N°14, pages 2563-2565* [2]. Elle consiste à déposer sur un substrat en silicium une couche de nitrure puis, après avoir ménagé des fenêtres de germination à travers celle-ci, à déposer par pulvérisation une couche de germanium, qui se trouve en contact avec la couche en nitrure et le substrat en silicium par le biais desdites fenêtres. Après encapsulation, la structure résultante est portée à la température de fusion du germanium, le germanium recristallisant en se propageant des fenêtres de germination vers la couche de nitrure, pour former une structure comprenant respectivement un substrat en silicium, une couche de nitrure et une couche de germanium. Cette technique est toutefois lourde et la recristallisation est limitée à la fois en étendue et en géométrie du fait des problèmes de stabilité d'interface.

La dernière technique proposée dans la littérature est le procédé de condensation du germanium, tel que décrit dans Applied Physics Letters, Vol . 83, N°17, pages 3516-3518 [3]. Cette technique est basée sur le principe de l'oxydation sélective du silicium par rapport au germanium. La première étape consiste en l'épitaxie d'une couche d'alliage silicium germanium SiGe sur un substrat silicium-sur-isolant (SOI). La deuxième étape est une oxydation sèche à haute température permettant la formation exclusive de l'oxyde de silicium SiO₂ due à une enthalpie de formation négative plus importante que celle de l'oxyde de germanium GeO₂. Au cours de l'oxydation, le germanium se trouve piégé entre deux barrières : l'interface avec l'oxyde enterré et l'interface avec l'oxyde de silicium en cours de formation. Le germanium reste confiné entre ces deux barrières, tandis que le silicium diffuse en direction de la couche d'oxyde de silicium en formation. L'épaisseur de la couche d'alliage silicium-germanium diminuant, la concentration en germanium s'enrichit durant l'oxydation et peut atteindre 100% pour la formation d'un GeOI pour un temps d'oxydation adapté. Toutefois, en fin de procédé, lorsque la totalité du silicium est consommé, le germanium s'oxyde à son tour en une couche d'oxyde de germanium GeO₂. Compte tenu des très fines épaisseurs de GeOI obtenues (de l'ordre de 10 nm), une consommation totale du germanium est très rapidement réalisée. Ainsi, pour l'obtention de substrats GeOI (Germanium-on-insulator), le temps de procédé doit être calculé précisément pour oxyder le silicium sans consommation du germanium. Il a été constaté également que de faibles différences sur l'épaisseur du silicium du SOI, l'épaisseur et la concentration de la couche d'alliage SiGe épitaxié, produisent d'énormes différences sur l'épaisseur et la concentration du germanium après condensation. Les meilleures structures de départ, avec un substrat SOI le plus homogène existant et une épitaxie la plus optimisée possible, ne permettent pas d'obtenir des structures homogènes après condensation. Ainsi, lors d'un enrichissement atteignant 100% pour la réalisation de GeOI, une consommation locale de germanium par oxydation est inévitable.

Il existe donc un véritable besoin concernant un procédé de fabrication d'une couche de germanium à partir d'un substrat SGOI qui empêche la consommation du germanium une fois que tout le silicium ait été consommé et qui plus est, puisse, le cas échéant, permettre une co-intégration SOI-GeOI.

### EXPOSE DE L'INVENTION

Les Inventeurs ont découvert, de manière surprenante, qu'en mettant en oeuvre une réaction de siliciuration sélective par rapport à une réaction de germaniuration, il était possible de surmonter les inconvénients de l'art antérieur, et notamment d'éviter la consommation de germanium une fois que le silicium est consommé.

Ainsi, l'invention a pour objet un procédé d'élaboration d'une couche de germanium sur isolant à partir d'un substrat SGOI comprenant :
a) une étape de dépôt sur ledit substrat d'une couche en un élément métallique M apte à former sélectivement un siliciure, ladite couche étant en contact avec une couche d'alliage silicium-germanium ;
b) une étape de réaction entre ladite couche d'alliage et ladite couche en un élément métallique M, moyennant quoi l'on obtient une superposition de couches siliciure de M-Germanium-Isolant.

Le procédé de l'invention présente ainsi, par rapport aux procédés de l'art antérieur, les avantages suivants :
- il permet d'obtenir une couche de germanium n'étant pas consommée dans les conditions opératoires du procédé ;
- il permet à partir d'un alliage silicium-germanium d'obtenir une couche comprenant la totalité du germanium présente dans l'alliage, du fait que le germanium n'est pas consommé dans les conditions opératoires du procédé, tandis que le silicium de l'alliage est entièrement consommé, pour former le siliciure de M ;
- il permet l'obtention de structures SOI et GeOI sur un même wafer permettant une cointégration.

Selon l'invention, ledit substrat (sur lequel est déposée la couche métallique) est un SGOI, à savoir un substrat silicium-germanium-sur-isolant, l'isolant pouvant former un oxyde enterré, par exemple, en silice. L'isolant peut également consister en une couche d'air. Ce substrat peut comprendre entre la couche d'isolant et la couche d'alliage silicium-germanium une couche intercalaire en silicium métallique. La couche d'isolant, quant à elle peut reposer sur une couche de silicium métallique. En particulier, le substrat SGOI peut comprendre respectivement une couche de base en silicium, une couche d'oxyde enterré sur ladite couche de base et une couche en alliage silicium-germanium sur ladite couche d'oxyde enterré. Le substrat SGOI peut comprendre, en outre, une couche de silicium disposée entre ladite couche d'oxyde enterré et ladite couche en alliage silicium-germanium. De préférence, la couche en alliage silicium-germanium est monocristalline.

Selon la première étape du procédé, il est procédé au dépôt sur le substrat SGOI d'une couche en un élément métallique M apte à former sélectivement un siliciure, cette couche étant ainsi en contact avec la couche d'alliage silicium-germanium. Notamment lorsque l'isolant du substrat consiste en une couche d'air, l'étape de dépôt d'une couche en un élément métallique M pourra se faire sur toutes les faces de la couche en alliage silicium-germanium.

Il peut être également procédé au dépôt d'une couche de siliciure de M sur ladite couche en un élément métallique M, selon le mode de réalisation envisagé, cette étape de dépôt étant mise en oeuvre entre l'étape a) et l'étape b).

L'élément métallique M doit être apte à réagir exclusivement avec le silicium pour former un siliciure de M et former ainsi une barrière vis-à-vis de la diffusion du germanium.

Un élément métallique M approprié répondant à ce critère peut être choisi avantageusement parmi le tantale, le rhénium et le tungstène.

De préférence, l'élément métallique M est le tungstène. L'épaisseur sera préférentiellement choisie plus importante que l'épaisseur nécessaire à la consommation totale de silicium.

Selon la deuxième étape du procédé de l'invention, il est procédé à la réaction entre la couche en élément métallique M et la couche d'alliage silicium-germanium, la couche en élément métallique M réagissant sélectivement avec le silicium, afin de former un siliciure de M, la totalité du silicium de l'alliage étant consommée pour former le siliciure, moyennant quoi l'on obtient à la fin de cette étape, l'enchaînement de couches suivant :
- éventuellement une couche de M n'ayant pas réagi ;
- une couche de siliciure M surmontant une couche de germanium ;
- une couche de germanium surmontant l'isolant.

L'étape de réaction peut être mise en oeuvre selon deux modes de réalisations, à savoir :
- soit par une étape de recuit en atmosphère neutre ;
- soit par une étape d'oxydation, auquel cas une couche de siliciure de M surmontera avantageusement la couche en un élément métallique M préalablement à la réaction, moyennant quoi l'on obtient, à l'issue de cette étape, une superposition de couches oxyde de silicium-siliciure de M-Germanium-Isolant.

Afin de mettre à jour la couche de germanium formée, le procédé de l'invention peut comprendre une étape d'élimination de la couche d'oxyde de silicium et/ou de la couche de siliciure de M.

Dans le cas où l'isolant du substrat SGOI consiste en une couche d'air, l'on peut à l'issue du procédé obtenir une structure comprenant deux couches : une couche d'oxyde de silicium et/ou de siliciure de M surmontant une couche de germanium. Après élimination de la couche d'oxyde de silicium ou de siliciure de M, l'on se retrouve avec une couche de germanium pur. Il est entendu que cette couche de germanium sera liée par des plots de soutien à un autre substrat. Le procédé de l'invention peut permettre ainsi la réalisation d'un pont suspendu de germanium pouvant être dénommé « GON » correspondant à la terminologie « Germanium-on-nothing », ce pont suspendu étant lié par deux plots de soutien à un autre substrat.

L'invention va maintenant être décrite plus en détail en référence aux modes de réalisation suivants et aux figures annexées.

### BREVE DESCRIPTION DES FIGURES

Les figures 1A et 1B sont des vues en coupe transversale illustrant le procédé de l'invention selon un premier mode de réalisation.
Les figures 2A à 2C sont des vues en coupe transversale illustrant le procédé de l'invention selon un second mode de réalisation.
La figure 3 représente un graphique illustrant l'enrichissement en germanium (% Ge) en fonction de l'épaisseur de tungstène déposé Ep W (en nm) pour un substrat comprenant une couche d'alliage Si_{0,9}Ge_{0,1} de 100 nm et un support SOI avec une couche de silicium de 20 nm.

### EXPOSE DETAILLE DE MODES DE REALISATION PARTICULIERS

Comme mentionné précédemment, le procédé de l'invention permet la fabrication d'une couche de germanium à partir d'un substrat SGOI basé sur une réaction sélective de siliciuration.

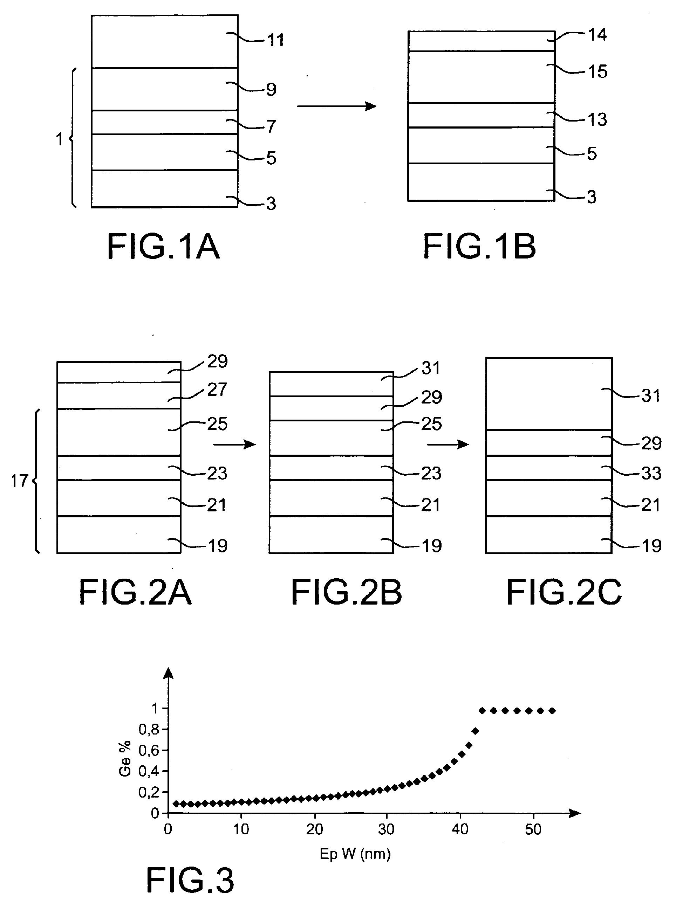

Les figures 1A et 1B illustrent un premier mode de réalisation de l'invention.

La figure 1A montre un substrat SGOI 1 approprié pour la mise en oeuvre de la présente invention. Le substrat 1 comprend un support de base en silicium 3. Le support 3 supporte, respectivement, une couche d'oxyde enterré 5, une couche de silicium 7 et une couche d'alliage silicium-germanium 9. La couche d'oxyde enterré peut être classiquement une couche d'oxyde de silice. La couche d'alliage silicium-germanium 9 est surmontée d'une couche en un élément métallique M 11, lequel est apte à former sélectivement un siliciure. Cette couche 11 est déposée généralement par dépôt chimique en phase vapeur (correspondant à l'abréviation CVD) ou peut être pulsée sur le substrat SGOI 1. Le substrat ainsi obtenu est soumis, selon ce mode de réalisation, à une étape de recuit sous atmosphère neutre.

Cette étape de recuit permet une diffusion du silicium présent dans la couche de silicium 7 et dans la couche d'alliage silicium-germanium 9 vers la couche d'un élément métallique M 11, lesdits atomes de silicium réagissant avec M, de façon à former une couche de siliciure de M. Les atomes de germanium diffusent également mais restent localisés entre la couche d'oxyde enterré et la couche de siliciure en formation, du fait que le germanium ne réagit pas avec les atomes de M pour former un germaniure.

On précise que, par atmosphère neutre, on entend une atmosphère dénuée d'oxygène et de tout composé réactif oxydant ou réducteur, cette atmosphère pouvant être une atmosphère d'azote ou une atmosphère de gaz rare,-tel que l'argon.

L'étape de recuit est réalisée très avantageusement à une température inférieure à la température de fusion du germanium (à savoir 938,3°C) mais à une température efficace pour permettre une diffusion du germanium et du silicium dans l'alliage silicium-germanium, de préférence supérieure à 700°C. Cette diffusion permettra une substitution du germanium par du silicium à l'interface de la couche d'alliage et de la couche en élément métallique M, créant ainsi une force motrice pour la réaction sélective de siliciuration. L'élément métallique M constitutif de la couche M peut être le tungstène, le rhénium et le tantale. En ce qui concerne le rhénium et le tantale, la température de l'étape de recuit sera comprise avantageusement dans l'intervalle allant de 700 à 900°C. Lors de l'étape de recuit selon ce mode de réalisation, le silicium de la couche de silicium 7 et de la couche d'alliage 9 est consommé pour former le siliciure.

Une fois l'étape de recuit réalisée, la couche de germanium se trouve piégée entre deux barrières : une barrière constituée par la couche d'oxyde enterré et une barrière constituée par la couche de siliciure ainsi formé lors de la réaction sélective de siliciuration. L'on obtient ainsi un substrat, représenté sur la figure 1B, comprenant respectivement la succession des couches suivantes :
- un support en silicium 3 ;
- une couche d'oxyde enterré 5 ;
- une couche en germanium 13 ;
- une couche en siliciure de M 15 ;
- une couche de M excédentaire 14.

L'épaisseur de la couche de M, avant l'étape de siliciuration sélective, sera avantageusement supérieure à l'épaisseur minimale nécessaire à une consommation totale du silicium.

Que ce soit pour ce mode de réalisation ou pour d'autres modes, le procédé de l'invention permet l'obtention de substrats GeOI (Germanium-sur-isolant) localisés par simple dépôt d'une couche métallique sur les zones que l'on souhaite enrichir en germanium. Ces substrats, comme il est représenté sur la figure 1B, sont recouverts à l'issue du procédé d'une couche de siliciure et, dans ce cas de figure, une couche de métal M excédentaire.

Afin de pouvoir utiliser le germanium comme substrat pour la conception de dispositifs électroniques, tels que les transistors MOSFET, il importe de procéder à l'élimination de cette couche de siliciure.

Ainsi, le procédé de l'invention peut comprendre, que ce soit pour le premier mode de réalisation décrit ci-dessus ou pour d'autres modes, une étape d'élimination de la couche de siliciure formée. Cette étape d'élimination peut consister à mettre en contact la structure obtenue avec des ions fluorures et de l'azote, les ions fluorures permettant la gravure sélective de la couche de siliciure par rapport à la couche de germanium sous-jacente et l'azote permettant la passivation de la couche de germanium affleurante après l'élimination de la couche de siliciure. Un mélange approprié permettant d'apporter des ions fluorures et de l'azote est le mélange SF₆/N₂, ce mélange pouvant être mis sous forme de plasma gazeux pour l'étape d'élimination.

Afin d'assurer un enrichissement contrôlé en germanium, il peut être envisageable de répéter une ou plusieurs fois le cycle d'étapes suivantes :
- étape de dépôt d'une couche en élément métallique M ;
- étape de réaction sélective de siliciuration ;
- étape d'élimination de la couche de siliciure formée.

Après l'étape de dépôt de la couche en élément métallique M, il peut être envisageable de déposer sur celle-ci une couche en nitrure de silicium, afin d'empêcher un potentiel démouillage du siliciure lors du recuit.

Les figures 2A à 2C illustrent un second mode de réalisation de l'invention, mettant toujours en oeuvre une étape de siliciuration sélective.

La figure 2A montre un substrat SGOI 17 comprenant la succession de couches suivante :
- une couche de base en silicium 19 ;
- une couche d'oxyde enterré 21 sur ladite couche de base 19 ;
- une couche de silicium 23 sur ladite couche d'oxyde enterré 21 ;
- une couche en alliage silicium-germanium 25 sur ladite de silicium 23 ;

Sur ce substrat SGOI est déposée une couche en un élément métallique M 27 puis sur cette couche 27 une couche en siliciure de M 29, ces dépôts pouvant être effectués par voie chimique en phase vapeur (CVD) ou voie physique en phase vapeur (PVD).

Le substrat résultant est soumis, ensuite, selon ce mode de réalisation à une étape d'oxydation, moyennant quoi il se forme sur la couche de siliciure de M 29 une couche d'oxyde de silicium 31. De façon concomitante, le silicium présent dans la couche de silicium 23 et la couche en alliage silicium-germanium 25 diffuse à travers la couche de siliciure 29 pour accéder à l'interface formée entre ladite couche de siliciure 29 et la couche en oxyde de silicium 31 en formation (cf. figure 2B). Le germanium, présent dans la couche en alliage silicium-germanium 25 ne diffuse pas à travers la couche de siliciure, dans la mesure où il ne présente pas d'affinité pour le métal M et reste ainsi confiné, entre la couche en silicium 23 et la couche en siliciure de M 29. L'étape d'oxydation est maintenue jusqu'à consommation totale du silicium présent à la fois dans la couche de silicium 23 et dans la couche en alliage silicium-germanium 25. La couche en siliciure protège le germanium du phénomène d'oxydation.

L'étape d'oxydation peut être réalisée par voie sèche, par exemple, en chauffant à une température d'oxydation supérieure à 700°C et inférieure à 938°C, par exemple pendant une durée allant de quelques dizaines de minutes à quelques heures, sous atmosphère d'oxygène. Une durée d'oxydation de 3 heures sera avantageusement choisie pour s'assurer de la consommation totale du silicium.

L'étape d'oxydation peut être réalisée également par voie humide avec une température d'oxydation comprise entre 700 et 938°C sous H₂O et HCl.

A l'issue de ce mode de réalisation, on obtient ainsi un substrat représenté sur la figure 2C comprenant la succession de couches suivante :
- une couche de base en silicium 19 ;
- une couche d'oxyde enterré 21 sur ladite couche de base 19 ;
- une couche en germanium 33 sur ladite couche d'oxyde enterré 21 ;
- une couche en siliciure de M 29 sur ladite couche en germanium 33 ;
- une couche en dioxyde de silicium 31 sur ladite couche en siliciure de M 29.

Afin de pouvoir utiliser le germanium comme substrat pour la conception de dispositifs électroniques, tels que les transistors MOSFET, il importe de procéder à l'élimination de cette couche de siliciure et de cette couche d'oxyde de silicium.

Pour ce faire, la couche d'oxyde de silicium formée peut être éliminée par gravure chimique en voie humide (mélanges HF/H₂O ou HF/NH₄F) ou en voie sèche. Quant à la couche de siliciure, elle peut être éliminée de la façon explicitée ci-dessus, à savoir avec un mélange comprenant des ions fluorures et un gaz neutre, tel que N₂.

La couche de germanium mise à nu peut ainsi servir de base pour la réalisation de dispositifs électroniques, tels que des transistors MOSFET.

L'originalité de ce procédé, outre le fait de permettre la formation d'une couche de germanium à partir d'un substrat SGOI, repose aussi sur le fait de faire intervenir une couche d'un élément métallique, afin de générer une couche de germanium qui servira de base à la fabrication de dispositifs électroniques, alors qu'il est de pratique courante de ne faire intervenir une couche d'un élément métallique qu'en fin de fabrication de dispositifs électroniques, notamment pour assurer le contact électrique, et ce afin d'éviter les problèmes de contamination inhérents à l'utilisation de ce type de couche.

Ainsi, l'invention a trait également à un procédé de fabrication d'un dispositif électronique comprenant :
- une étape de mise en oeuvre du procédé d'élaboration d'une couche de germanium-sur-isolant à partir d'un substrat SGOI tel que défini ci-dessus ;
- une étape de réalisation des éléments constitutifs dudit dispositif électronique sur ladite couche de germanium.

Ce dispositif électronique peut être notamment un transistor MOSFET, auquel cas la couche de germanium pourra constituer le canal de ce transistor, les autres éléments constitutifs à réaliser sur la couche de germanium étant la source, le drain, la grille, les espaceurs.

L'invention va maintenant être décrite par rapport à l'exemple suivant.

### Exemple 1

Cet exemple illustre la préparation d'une couche de germanium à partir de substrats comprenant :
- un support SOI (silicium-sur isolant) avec une couche de silicium présentant une épaisseur de 20 nm ;
- une couche d'alliage silicium-germanium Si_{0,9}Ge_{0,1} présentant une épaisseur de 100 nm épitaxiée, à partir de ladite de couche de silicium ;
- une couche de tungstène de différentes épaisseurs, de façon à déterminer l'épaisseur optimale pour obtenir une couche de germanium pur (c'est-à-dire dénuée de silicium).

Les différentes épaisseurs de tungstène testées sont comprises entre 0 et 50 nm.

Comme il ressort de la figure 3, l'on obtient, dans les conditions opératoires de l'exemple, une couche de germanium pur, pour une épaisseur de couche de tungstène déposé supérieur à 43 nm.

## Revendications

1. Procédé d'élaboration d'une couche de germanium sur isolant à partir d'un substrat SGOI comprenant une couche d'alliage silicium-germanium, une couche d'isolant et éventuellement une couche intercalaire en silicium métallique disposée entre ladite couche d'alliage silicium-germanium et ladite couche d'isolant, ledit procédé comprenant :
a) une étape de dépôt sur ledit substrat d'une couche en un élément métallique M apte à former sélectivement un siliciure, ladite couche étant en contact avec ladite couche d'alliage silicium-germanium ;
b) une étape de réaction entre ladite couche d'alliage silicium-germanium et ladite couche en un élément métallique M, moyennant quoi l'on obtient une superposition de couches siliciure de M-Germanium-Isolant.

2. Procédé selon la revendication 1, dans lequel l'élément métallique M est choisi parmi le tantale, le rhénium, le tungstène.

3. Procédé selon la revendication 1 ou 2, dans lequel l'élément métallique M est le tungstène.

4. Procédé selon l'une quelconque des revendications précédentes, dans lequel le substrat SGOI comprend respectivement une couche de base en silicium, une couche d'oxyde enterré sur ladite couche de base et une couche en alliage silicium-germanium sur ladite couche d'oxyde enterré.

5. Procédé selon la revendication 4, dans lequel le substrat SGOI comprend, en outre, une couche de silicium disposée entre ladite couche d'oxyde enterré et ladite couche en alliage silicium-germanium.

6. Procédé selon l'une quelconque des revendications précédentes, dans lequel l'étape de réaction b) entre la couche en un élément métallique M et le substrat consiste en un recuit sous atmosphère neutre à une température inférieure à la température de fusion du germanium.

7. Procédé selon la revendication 6, dans lequel le recuit est réalisé à une température supérieure à 700°C.

8. Procédé selon l'une quelconque des revendications 1 à 5, comprenant en outre, après l'étape a) et avant l'étape b), une étape de dépôt d'une couche en siliciure de M sur la couche en un élément métallique M.

9. Procédé selon la revendication 8, comprenant une étape d'oxydation, moyennant quoi l'on obtient une superposition de couches oxyde de silicium-siliciure de M-Germanium-Isolant.

10. Procédé selon la revendication 1 ou 8, comprenant en outre, une étape d'élimination de la couche d'oxyde de silicium et/ou de la couche de siliciure de M.

11. Procédé selon la revendication 10, dans lequel l'élimination de la couche de siliciure de M est réalisée par mise en contact de ladite couche avec un mélange comprenant des ions fluorures et un gaz neutre.

12. Procédé de fabrication d'un dispositif électronique comprenant ;
- une étape de mise en oeuvre du procédé d'élaboration d'une couche de germanium sur isolant à partir d'un substrat SGOI tel que défini à la revendication 11;
- une étape de réalisation des éléments constitutifs dudit dispositif électronique sur ladite couche de germanium.

13. Procédé selon la revendication 12, dans lequel le dispositif électronique est un transistor MOSFET.

14. Procédé selon la revendication 13, dans lequel les éléments constitutifs sont le canal, la source, le drain, la grille et les espaceurs.

## Claims

1. Method for making a germanium-on-insulator layer from an SGOI substrate comprising a silicon-germanium alloy layer, an insulator layer and possibly an intermediate layer of metallic silicon between the silicon-germanium layer and the insulator layer, said process comprising:
a) a step of depositing on the said substrate a layer of a metallic element M capable of selectively forming a silicide, the said layer being in contact with a silicon-germanium alloy layer;
b) a step of a reaction between the said silicon-germanium alloy layer and the said layer of a metallic element M, by means of which a stack of M silicide-germanium-insulator layers is obtained.

2. Method according to Claim 1, **characterized in that** the metallic element M is selected from tantalum, rhenium, tungsten.

3. Method according to Claim 1 or 2, **characterized in that** the metallic element M is tungsten.

4. Method according to any one of the preceding claims, **characterized in that** the SGOI substrate respectively comprises a silicon base layer, a buried oxide layer on the said base layer and a silicon-germanium alloy layer on the said buried oxide layer.

5. Method according to Claim 4, **characterized in that** the SGOI substrate furthermore comprises a silicon layer between the said buried oxide layer and the said silicon-germanium alloy layer.

6. Method according to any one of the preceding claims, **characterized in that** the step b) of reaction between the layer of a metallic element M and the substrate consists of an anneal in a neutral atmosphere at a temperature below the melting temperature of germanium.

7. Method according to Claim 6, **characterized in that** the anneal is carried out at a temperature above 700°C.

8. Method according to any one of Claims 1 to 5, furthermore comprising a step of depositing a layer of M silicide on the layer of a metallic element M, after step a) and before step b).

9. Method according to Claim 8, comprising an oxidation step, by means of which a stack of silicon oxide-M silicide-germanium-insulator layers is obtained.

10. Method according to Claim 1 or 8, furthermore comprising a step of removing the silicon oxide layer and/or the layer of M silicide.

11. Method according to Claim 10, **characterized in that** the layer of M silicide is removed by bringing the said layer in contact with a mixture comprising fluoride ions and a neutral gas.

12. Method for fabricating an electronic device, comprising:
- a step of carrying out the method for making a germanium-on-insulator layer from an SGOI substrate as defined in Claim 11;
- a step of producing constituent elements of the said electronic device on the said germanium layer.

13. Method according to Claim 12, **characterized in that** the electronic device is a MOSFET transistor.

14. Method according to Claim 13, **characterized in that** the constituent elements are the channel, the source, the drain, the gate and the spacers.

## Patentansprüche

1. Verfahren zur Herstellung einer Germanium-Schicht auf einem Isolator, ausgehend von einem SGOI-Substrat, weiches eine Silizium-Germanium-Legierung-Schicht, eine Isolatorschicht und gegebenenfalls eine Zwischenschicht aus metallischem Silizium umfasst, die zwischen der Silizium-Germanium-Legierung-Schicht und der Isolatorschicht angeordnet ist, wobei das Verfahren umfasst:
a) einen Schritt des Aufbringens einer Schicht aus einem metallischen Element M, welches dazu geeignet ist, selektiv ein Silicid zu bilden, auf dem Substrat, wobei diese Schicht in Kontakt mit der Silizium-Germanium-Legierung-Schicht steht,
b) einen Schritt der Reaktion zwischen der Silizium-Germanium-Legierung-Schicht und der Schicht aus einem metallischen Element M, was dazu führt, dass eine Überlagerung von Schichten M-Silicid - Germanium - Isolator erhalten wird.

2. Verfahren nach Anspruch 1, wobei das metallische Element M ausgewählt ist aus Tantal, Rhenium und Wolfram.

3. Verfahren nach Anspruch 1 oder 2, wobei das metallische Element M Wolfram ist.

4. Verfahren nach einem der vorhergehenden Anspruche, wobei das SGOI-Substrat jeweils eine Basisschicht aus Silizium, eine Oxidschicht, die auf der Basisschicht vergraben ist, und eine Silizium-Germanium-Legierung-Schicht auf der vergrabenen Oxidschicht umfasst.

5. Verfahren nach Anspruch 4, wobei das SGOI-Substrat weiterhin eine Siliziumschicht umfasst, die zwischen der vergrabenen Oxidschicht und der Silizium-Germanium-Legierung-Schicht angeordnet ist.

6. Verfahren nach einem der vorhergehenden Ansprüche, wobei der Schritt der Reaktion b) zwischen der Schicht aus einem metallischen Element M und dem Substrat in einem Erhitzen unter einer neutralen Atmosphäre bei einer Temperatur besteht, die kleiner ist als die Schmelztemperatur von Germanium.

7. Verfahren nach Anspruch 6, wobei das Erhitzen bei einer Temperatur von mehr als 700 °C durchgeführt wird.

8. Verfahren nach einem der Ansprüche 1 bis 5, weiterhin umfassend, nach dem Schritt a) und vor dem Schritt b) einen Schritt des Aufbringens einer M-Silicid-Schicht auf die Schicht aus einem metallischen Element M.

9. Verfahren nach Anspruch 8, umfassend einen Schritt der Oxidation, welcher dazu führt, dass man eine Überlagerung von Schichten Siliziumoxid - M-Silicid - Germanium - Isolator erhält.

10. Verfahren nach Anspruch 1 oder 8, weiterhin umfassend einen Schritt der Eliminierung der Siliziumoxidschicht oder/und der M-Silicidschicht.

11. Verfahren nach Anspruch 10, wobei die Eliminierung der M-Silicidschicht durchgeführt wird, indem die Schicht mit einer Mischung in Kontakt gebracht wird, welche Fluoridionen und ein neutrales Gas umfasst.

12. Verfahren zur Herstellung eines elektronischen Bauteils, umfassend:
- einen Schritt der Durchführung des Verfahrens zur Herstellung einer Germanium-Schicht auf einem Isolator, ausgehend von einem SGOI-Substrat, so wie in Anspruch 11 definiert,
- einen Schritt der Herstellung von Bestandteilen des elektronischen Bauteils auf der Germanium-Schicht.

13. Verfahren nach Anspruch 12, wobei das elektronische Bauteil ein MOSFET-Transistor ist.

14. Verfahren nach Anspruch 13, wobei die Bestandteile der Kanal, die Source-Elektrode, die Drain-Elektrode, die Gate-Eleirtrode und die Spacer sinn.
